# EUROPÄISCHE PATENTSCHRIFT

(11) **EP 0 669 794 B1**
(45) Veröffentlichungstag und Bekanntmachung des Hinweises auf die Patenterteilung: **14.05.2003**
(21) Anmeldenummer: 95102293.8
(22) Anmeldetag: 17.02.1995
(51) Int. Cl.: H05K 5/02, H05K 7/14

(54) **Gehäuse, das aus einem Basisgehäuseteil und einer Gehäuseabdeckung besteht**
Enclosure with a main body and a cover
Boîtier constitué d'une base et d'un cache

(30) Priorität: 25.02.1994 DE 9403210 U
(43) Veröffentlichungstag der Anmeldung: 30.08.1995
(73) Patentinhaber: SIEMENS AKTIENGESELLSCHAFT, 80333 München (DE)
(72) Erfinder: Verding, Markus, Dipl.-Ing., D-46286 Dorsten (DE); Ehm, Thomas, Dipl.-Ing., D-44265 Dortmund (DE)
(74) Vertreter: Berg, Peter, Dipl.-Ing.

(56) Entgegenhaltungen:
- EP-A- 0 437 370
- WO-A-90/04896
- DE-A- 3 046 928

## Beschreibung

Die Erfindung betrifft ein Gehäuse, das aus einem insbesondere zur Aufnahme von Leiterplatten dienenden Basisgehauseteil und einer lösbaren für den gesamten offen zugänglichen Bereich des bestimmungsgemäß bestückten Basisgehäuseteils vorgesehenen Gehäuseabdeckung gebildet wird, wobei ein von mindestens einer Gehäuseseite zugänglicher Anschlußbereich vorgesehen ist und die Bestückung der Leiterplatten zumindest teilweise ein Kommunikationssystem bildet; (siehe Z.B. EP-A-0437370).

Solche Gehäuse können beispielsweise als Wandgehäuse konzipiert sein und die Einheiten für ein Kommunikationssystem aufnehmen. Diese Einheiten stellen u.a. bestückte Leiterplatten dar, die mit Bezug auf ein Wandgehäuse in verschiedenen Ebenen hintereinander gelagert sein können. Durch eine abnehmbare Gehäuseabdeckung ist sicherzustellen, daß im Bedarfsfalle ein Zugriff zu den einzelnen Anschlußstellen möglich ist.

Es ist die Aufgabe der Erfindung die Gehäuseabdeckung für einen notwendigen anschlußseitigen Zugriff servicefreundlicher zu gestalten. Dies wird erfindungsgemäß dadurch gelöst, daß die Gehäuseabdeckung aus einem ersten Abdeckteil, das den genannten Anschlußbereich offen zugänglich läßt und aus einem diesen Anschlußbereich nach dem Aufbringen überdeckenden zweiten Abdeckteil gebildet wird, daß das zweite Abdeckteil lösbar mechanisch mit dem ersten Abdeckteil verbunden ist.

Dieser Anschlußbereich kann durch den jeweiligen Randbereich der einzelnen Leiterplatten definiert sein, an dem beispielsweise Verbindungssteckerelemente aufgebracht sind und der für Prüf- und Meßvorgänge zugänglich sein soll. Durch entsprechende Steckverbinder können die einzelnen Leiterplatten untereinander verbunden werden oder es können damit einzelne Versorgungs- bzw. Anschlußleitungen angeschlossen werden. Um eine einfache Zugänglichkeit an die Prüf- Meß- und Anschlußstellen zu ermöglichen, muß also nicht das erste Abdeckteil, das flächenmäßig bis auf eine in der Regel eine Teilfläche das Basisgehäuseteil nahezu abdeckt entfernt werden, sondern lediglich das die Teilfläche des Anschlußbereiches abdeckende zweite Abdeckteil. Ist dieses zweite Abdeckteil erfindungsgemäß auf das erste Abdeckteil aufgeschnappt, so läßt sich diese Schnappverbindung durch eine einfache manuelle Handhabung problemlos im Bedarfsfall lösen. Dies ist ohne Anwendung eines Werkzeuges möglich. Für das Abnehmen des ersten Abdeckteils, das beispielsweise auf das Basisgehäuseteil aufgerastet ist, kann die Anwendung eines Werkzeuges vorausgesetzt sein.

Weitere vorteilhafte Ausgestaltungen der Erfindung sind den restlichen Unteransprüchen zu entnehmen.

Die Erfindung soll im folgenden anhand eines Ausführungsbeispiels näher erläutert werden. Es zeigt
- Fig. 1: das durch ein erstes Abdeckteil abgedeckte Basisgehäuseteil sowie das nicht aufgeschnappte zweite Abdeckteil
- Fig. 2: die Seitenansicht des Gehäuses bei entsprechend der Fig. 1 losgelösten zweiten Abdeckteil
- Fig. 3: die Seitenansicht der bezogen auf ein Wandgehäuse unteren Seite bei entferntem zweiten Abdeckteil

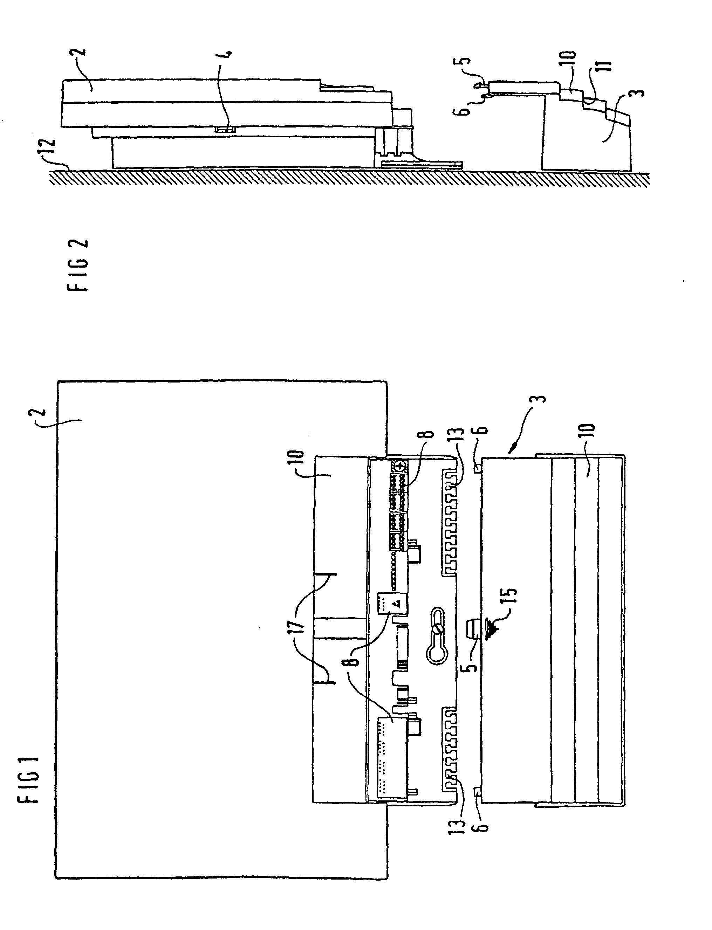

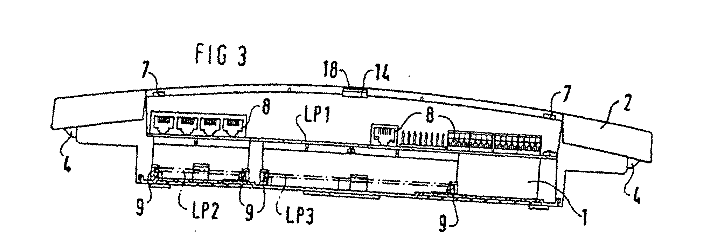

Das Basisgehäuseteil 1 kann wie in der Fig. 2 schematisch dargestellt an einer Wandfläche 12 befestigt werden. Das Basisgehäuseteil kann beispielsweise bestückte Leiterplatten aufnehmen, durch deren Bestückung ein Kommunikationssystem realisiert wird. Es kann darin ein sog. kleines Kommunikationssystem untergebracht werden, das nur eine geringe Anzahl von Kommunikationsanschlüssen aufweist. In diesem Basisgehäuseteil 1 können bestückte Leiterplatten in verschiedenen Ebenen übereinander bzw. auch nebeneinander angeordnet werden, wie dies die Fig. 3 für die Leiterplatten LP1 bis LP3 zeigt. Die Leiterplatte LP1 l liegt dabei an einer rahmenartigen Teilfläche des Basisgehäuseteils 1 auf und kann in nicht dargestellter Weise verriegelt werden. Die Leiterplatte LP2 kann in gleicher Weise wie die Leiterplatte LP3 in Führungschienen 9, die mit der Rückwand verbunden sind bis zu einem vorgegebenem Anschlag eingeschoben werden. In dieser durch den Anschlag vorgegebenen Zwangsendlage werden sie dann ebenfalls automatisch in nicht dargestellter Weise verriegelt.

Die im Falle eines Wandgehäuses unteren Endbereiche der Leiterplatten können für die Aufnahme der Anschlußelemente vorgesehen sein. Diese Anschlußelemente, die beispielsweise Verbindungsstecker der unterschiedlichsten Art sein können sind lediglich für die Leiterplatte LP1 durch die gleiche Positionsnummer 8 angedeutet. Dieser Endbereich der jeweiligen Leiterplatten ist allgemein als Anschlußbereich anzusehen. In diesen Bereich können durch die entsprechenden Steckverbindungen die einzelnen Leiterplatten untereinander verbunden werden und es ist auch der Bereich für die Zuführung von internen oder auch externen Leitungen. Für diese Leitungen können in den Einschnitten 13 der Rückwand des Basisgehäuseteils 1 beispielsweise sog. Kabelbinder befestigt werden. Dieser Anschlußbereich sollte bedarfsweise problemlos zugänglich sein. Ein solcher Zugriff ist für Prüf- Meßvorgänge und für Änderungen in der Leitungsführung notwendig.

Nach dem Einbringen der Leiterplatte LP1, die beispielsweise grundsätzlich die für ein Kommunikationssystem maßgeblichen Systemkomponenten aufweist, kann das erste Abdeckteil 2 auf das Basisgehäuseteil 1 aufgerastet werden. Diese Rastverbindung kann in üblicher Weise vermittels von am Abdeckteil vorhandenen Rasthaken erfolgen. Beim Zusammenfügen der beiden genannten Teile werden diese Rasthaken zunächst durch entsprechende Steuerflächen elastisch ausgelenkt und rasten anschließend an den entsprechenden Verriegelungsschultern in eine Sperrstellung ein. Dieses Einrasten kann beispielsweise in dem an der seitlichen Kante jeweils vorhandenen Ansatz 4 erfolgen. Dieser Ansatz 4 kann derart ausgestaltet sein, daß ein Zugriff für das Entriegeln dieser Rasthaken nur unter Verwendung eines entsprechenden Werkzeuges möglich ist. Damit kann dann sichergestellt werden, daß zu dieser Hauptplatine, d.h. zu den auf der Leiterplatte LP1 enthaltenen Bauelemente bzw. Baueinheiten der Zugriff durch Lösen des ersten Abdeckteils nicht ohne weiteres möglich ist.

Wie der Fig. 1 zu entnehmen ist, wird durch das erste Abdeckteil 2 der Anschlußbereich der Leiterplatten nicht überdeckt. Dies erfolgt durch ein zweites Abdeckteil 3, das auf das erste Abdeckteil aufgerastet bzw. aufgeschnappt wird. Hierzu wird das zweite Abdeckteil 3 in eine formmäßig daran angepaßte Absenkung des Abdeckteils 2 eingeschoben. Die Überlappungsfläche 10 weist zwei Auflaufschrägen 17 in Form von entsprechend keilförmig ausgebildeten Stegen auf, so daß beim Aufschieben die Rastnase 5 in die Öffnung 14 des Abdeckteils eingeführt wird und hinter eine entsprechend ausgebildete Verriegelungsschulter einrastet. Zur sicheren Führung werden die am zweiten Abdeckteil 3 vorhandenen Ansätze 6 in die entsprechenden Öffnungen 7 im ersten Abdeckteil eingeführt. Durch die seitlichen Ränder der gegenüber der Oberfläche des zweiten Abdeckteils 2 vertieften Fläche 10 wird das zweite Abdeckteil 3 beim Aufbringen geführt und zwangsläufig die Rastnase 5 in die Öffnung 14 eingeführt. Die elastische Rastnase 5 wird durch den Steg 18 ausgelenkt und hinterschnappt ihn in der Verriegelungsstellung. Ein manuell ausgeführter Druck auf die Teilfläche 15 ermöglicht das sofortige Lösen der mit dem ersten Abdeckteil 2 bestehenden mechanischen Verbindung.

Es ist möglich, bei abgenommenem Abdeckteil 3 und weiterhin aufgerastetem Abdeckteil 2 die Leiterplatten LP2 bzw. LP3 in die jeweiligen Führungen 9 einzuschieben.

Wie in Fig. 2 ersichtlich, ist die äußere Kontur des zweiten Abdeckteils 3 so gewählt, daß es sich bezogen auf die Gebrauchslage nach unten in Stufen verjüngt. Die Flächenbereiche 11 zwischen den einzelnen Stufen 10 sind mit Ausnahme von notwendigen Verbindungsstegen geschlitzt. Damit ist eine Entlüftung möglich, wobei gleichzeitig diese Entlüftungsschlitze im gebrauchsfertigen Montagezustand des Wandgehäuses als solche nicht unmittelbar zu erkennen sind. Die ästhetische Formgebung durch die Kontur dieses zweiten Abdeckteils ist also gleichzeitig mit einem technischen Vorteil gekoppelt.

Im gebrauchsfertigen Montagezustand des Wandgehäuses ist der Anschlußbereich, der durch den unteren Rand der eingebrachten Leiterplatten gebildet wird jederzeit in einfacher Weise zugänglich. Die Schnappverbindung kann durch einfache Druckausübung auf die in unmittelbarer Nähe der Rastnase auf vorgesehene Teilfläche 15 gelöst werden. Es wird nämlich dadurch die elastische Rastnase 5 nach hinten gebogen, so daß die Schnappverbindung dadurch gelöst wird und das zweite Abdeckteil problemlos abgenommen werden kann. Damit ist dann jederzeit der Bereich der Steckverbinder 8 zugänglich, so daß z.B. Umrangierungen in einfacher Weise durchgeführt werden können. Die Anschlußelemente sind damit auch jederzeit für Meßvorgänge oder für Prüfvorgänge zugänglich.

Zumindest im Überlappungsbereich des zweiten Abdeckteils mit dem ersten Abdeckteil ist die Fläche 10 derart gegenüber der Oberfläche gestuft, daß das darauf aufgeschnappte zweite Abdeckteil angenähert oberflächenbündig ansetzt. Im Ausführungsbeispiel weist der durch das erste Abdeckteil 2 abzudekkende Hauptbereich des Gehäuses eine größere Breite auf als der durch das zweite Abdeckteil 3 abzudeckende Bereich und dieses zweite Abdeckteil reicht über die Begrenzungslinie des ersten Abdeckteils nach unten gerichtet hinaus. Unterstützt durch den in der Fig. 3 erkennbaren Hinterschnitt für das Basisgehäuseteil wird damit insgesamt eine monitorartige Ausgestaltung des Gehäuses erreicht.

## Patentansprüche

1. Gehäuse, das aus einem Basisgehäuseteil (1) zur Aufnahme von Leiterplatten deren Bestückung zumindest teilweise ein Kommunikationssystem bildet und einer lösbaren für den gesamten offen zugänglichen Bereich des bestimmungsgemäß bestückten Basisgehäuseteils vorgesehenen Gehäuseabdeckung gebildet wird, wobei ein von mindestens einer Gehäuseseite zugänglicher Anschlußbereich vorhanden ist,
**dadurch gekennzeichnet,**
**daß** die Gehäuseabdeckung aus einem ersten Abdeckteil (2), das den genannten Anschlußbereich offen zugänglich läßt und aus einem diesen Anschlußbereich nach dem Aufbringen überdeckenden zweiten Abdeckteil (3) gebildet wird, daß das zweite Abdeckteil (3) lösbar mechanisch mit dem ersten Abdeckteil (2) verbindbar ist.

2. Gehäuse nach Anspruch 1,
**dadurch gekennzeichnet,**
**daß** das zweite Abdeckteil (3) mit dem ersten Abdeckteil (2) ausschließlich mittels einer Schnappverbindung mechanisch verbindbar ist.

3. Gehäuse nach Anspruch 1,
**dadurch gekennzeichnet,**
**daß** das erste Abdeckteil (2) mit dem Basisgehäuseteil (1) durch eine Rastverbindung verbindbar ist.

4. Gehäuse nach einem der Ansprüche 1 bis 3,
**dadurch gekennzeichnet,**
**daß** das erste Abdeckteil (2) nach seinem Aufbringen unter Verwendung eines Werkzeuges erneut lösbar ist und daß das zweite Abdeckteil (3) ohne Werkzeug durch eine einfache Handhabung lösbar ist.

5. Gehäuse nach Anspruch 1,
**dadurch gekennzeichnet,**
**daß** der Anschlußbereich durch den einander benachbarten Randbereich einer jeden einzubringenden Leiterplatte (LP1 bis LP3) gebildet wird.

6. Gehäuse nach Anspruch 1 oder 2,
**dadurch gekennzeichnet,**
**daß** das zweite Abdeckteil (3) das erste Abdeckteil (2) teilweise überlappt und im Überlappungsbereich (10) und/oder an der inneren Begrenzungslinie dieses Überlappungsbereiches die Elemente (14, 17, 18) zur mechanischen Verbindung zwischen den beiden Abdeckteilen (3, 2) vorgesehen sind.

7. Gehäuse nach Anspruch 6,
**dadurch gekennzeichnet,**
**daß** das zweite Abdeckteil (3) zumindest im nicht überlappenden Bereich stufenweise verjüngend zum freien Ende hin ausgebildet ist und daß im Übergangsbereich der einzelnen Stufen (10) Lüftungsschlitze (11) vorgesehen sind.

8. Gehäuse nach Anspruch 6,
**dadurch gekennzeichnet,**
**daß** im Überlappungsbereich das erste Abdeckteil (2) eine derart abgestufte Teilfläche (10) aufweist, daß das aufgeschnappte zweite Abdeckteil angenähert oberflächenbündig ansetzt.

9. Gehäuse nach Anspruch 1 oder 2,
**dadurch gekennzeichnet,**
**daß** die Seitenwände des aufgebrachten zweiten Abdeckteils (3) jeweils in der Ebene der Seitenwände des Basisgehäuseteils (1) liegen.

10. Gehäuse nach Anspruch 1,
**dadurch gekennzeichnet,**
**daß** der durch das erste Abdeckteil abzudeckende Bereich gegenüber dem durch das zweite Abdeckteil (3) abzudeckenden Bereich eine größere Breite aufweist und das zweite Abdeckteil (2) über das erste Abdeckteil (3) einseitig hinausragt.

11. Gehäuse nach einem der vorhergehenden Ansprüche,
**dadurch gekennzeichnet,**
**daß** es als Wandgehäuse verwendet wird.

## Claims

1. Enclosure, which is formed from a main body (1) for accommodating printed circuit boards whose population at least to some extent forms a communications system, and a detachable cover provided for the entire open accessible region of the main body populated as intended, there being provided a connection area accessible from at least one side of the enclosure, **characterized in that** the cover is formed from a first cover part (2), which leaves the aforementioned connection area open and accessible, and a second cover part (3) which covers this connection area after it has been fitted, and **in that** the second cover part (3) can be connected detachably mechanically to the first cover part (2).

2. Enclosure according to Claim 1, **characterized in that** the second cover part (3) can be connected mechanically to the first cover part (2) exclusively by means of a snap-action connection.

3. Enclosure according to Claim 1, **characterized in that** the first cover part (2) can be connected to the main body (1) by a latching connection.

4. Enclosure according to one of Claims 1 to 3, **characterized in that** the first cover part (2) can be detached again by using a tool after it has been fitted, and **in that** the second cover part (3) can be detached without a tool by means of simple handling.

5. Enclosure according to Claim 1, **characterized in that** the connection area is formed by the mutually adjacent edge region of each printed circuit board (LP1 to LP3) to be introduced.

6. Enclosure according to Claim 1 or 2, **characterized in that** the second cover part (3) partly overlaps the first cover part (2) and, in the overlap region (10) and/or at the inner boundary line of this overlap region, the elements (14, 17, 18) for the mechanical connection between the two cover parts (3, 2) are provided.

7. Enclosure according to Claim 6, **characterized in that** the second cover part (3), at least in the non-overlapping region, is designed to taper in steps towards the free end, and **in that** ventilation slots (11) are provided in the transition region of the individual steps (10).

8. Enclosure according to Claim 6, **characterized in that** in the overlapping region, the first cover part (2) has a subarea (10) which is stepped in such a way that the second cover part snapped on is fitted approximately flush with the surface.

9. Enclosure according to Claim 1 or 2, **characterized in that** the side walls of the fitted second cover part (3) in each case lie in the plane of the side walls of the main body (1).

10. Enclosure according to Claim 1, **characterized in that** the region to be covered by the first cover part has a greater width as compared with the region to be covered by the second cover part (3), and the second cover part (3) projects beyond the first cover part (2) on one side.

11. Enclosure according to one of the preceding claims, **characterized in that** it is used as a wall-mounted enclosure.

## Revendications

1. Boîtier qui est constitué d'une base (1) de réception de plaquettes à circuit imprimé, dont les composants forment au moins en partie un système de communication, et d'un cache amovible prévu pour toute la partie accessible ouverte de la base de composants conforme aux prescriptions, dans lequel il y a une partie de raccordement accessible par au moins une face du boîtier,
**caractérisé**
**en ce que** le cache du boîtier est formé d'une première partie de cache qui laisse ouverte et accessible ladite partie de raccordement, et d'une deuxième partie (3) de cache recouvrant cette partie de recouvrement après l'application en ce que la deuxième partie (3) peut être reliée de façon amovible mécaniquement à la première partie de cache.

2. Boîtier suivant la revendication 1, **caractérisé en ce que** la deuxième partie (3) de cache peut être reliée mécaniquement à la première partie (2) de cache exclusivement au moyen d'une liaison à enclenchement.

3. Boîtier suivant la revendication 1, **caractérisé en ce que** la première partie (2) de cache peut être reliée à la base (1) par une liaison par encliquetage.

4. Boîtier suivant l'une des revendications 1 à 3, **caractérisé en ce que** la première partie 2 de cache peut être, après son application, redétachée en utilisant un outil et **en ce que** la deuxième partie (3) de cache peut être redétachée sans outil par une simple manipulation.

5. Boîtier suivant la revendication 1, **caractérisé en ce que** la partie de raccordement est formée par les parties de bord voisines l'une de l'autre de chaque plaquette (LP1 à LP3) à circuit imprimé à mettre.

6. Boîtier suivant la revendication 1 ou 2, **caractérisé en ce que** la deuxième partie (3) de cache recouvre en partie la première partie (2) de cache et dans la partie de recouvrement et/ou sur la ligne intérieure de démarcation de ces parties de recouvrement sont prévus les éléments (14, 17, 18) de liaison mécanique entre les deux parties (3, 2) de cache.

7. Boîtier suivant la revendication 6, **caractérisé en ce que** la deuxième partie (3) de cache se rétrécit vers l'extrémité libre par palier dans la partie qui n'est pas à recouvrement et **en ce que** dans la partie de transition des paliers (10) individuels, il est prévu des ouïes (11) d'aération.

8. Boîtier suivant la revendication 6, **caractérisé en ce que** dans la partie de recouvrement la première partie (2) de cache a une surface (10) partielle échelonnée de façon à ce que la deuxième partie de cache enclenchée soit à peu près à affleurement de surface.

9. Boîtier suivant la revendication 1 ou 2, **caractérisé en ce que** les parois latérales de la deuxième partie (3) de cache appliquée se trouvent respectivement dans le plan des parois latérales de la base (1).

10. Boîtier suivant la revendication 1, **caractérisé en ce que** la partie recouvrant la première partie de cache a, par rapport à la partie recouvrant la deuxième partie (3) de cache, une largeur plus grande et la deuxième partie (2) de cache dépasse d'un côté de la première partie (3) de cache.

11. Boîtier suivant l'une des revendications précédentes, **caractérisé en ce qu'**il est utilisé comme boîtier mural.
